# EUROPÄISCHE PATENTANMELDUNG

(11) **EP 2 756 907 A1**
(43) Veröffentlichungstag der Anmeldung: **23.07.2014**
(21) Anmeldenummer: 13151995.1
(22) Anmeldetag: 21.01.2013
(51) Int. Cl.: B23K 9/04, B23K 26/34, B23P 6/00, B23P 6/04, F01D 5/00

(54) **Auftragsschweißen mit äußerer dickerer Rahmenkontur**

(71) Anmelder: Siemens Aktiengesellschaft, 80333 München (DE)
(72) Erfinder: Burbaum, Bernd, 14612 Falkensee (DE)

(57) **Zusammenfassung**

Durch einen veränderten Auftragsprozess im Bereich der Kante, die eine zu schweißende Oberfläche (13)umrunden, wird die Rissanfälligkeit im Bereich der Kanten (16) verhindert, indem entweder ein breiteres Material oder ein anderes Material für die Außenkonturschweißung (2) verwendet wird.

## Beschreibung

Die Erfindung betrifft das Auftragsschweißen auf eine Oberfläche.

Auftragsschweißverfahren, insbesondere Laserauftragsschweißverfahren sind Stand der Technik und werden insbesondere auch bei Turbinenschaufeln verwendet, um die Schaufelspitze mit ihrer Kontur großflächig oder wandförmig aufzubauen.

Der Randbereich stellt immer noch eine kritische Stelle dar, sowohl beim Auftragsschweißen als auch bei der Rissanfälligkeit, da dies ein Übergang vom Material zur Luft ist.

Es ist daher Aufgabe der vorliegenden Erfindung o. g. Problem zu lösen.

Die Aufgabe wird gelöst durch ein Verfahren gemäß Anspruch 1 und ein Bauteil gemäß Anspruch 6.

In den Unteransprüchen sind weitere vorteilhafte Maßnahmen aufgelistet, um weitere Vorteile zu erzielen, die jeweils miteinander kombiniert werden können.

Es zeigen:
- Figur 1: ein Substrat im Querschnitt,
- Figur 2: eine Aufsicht auf eine geschweißte Fläche,
- Figur 3: eine Turbinenschaufel.

Die Figuren und die Beschreibung stellen nur Ausführungsbeispiele der Erfindung dar.

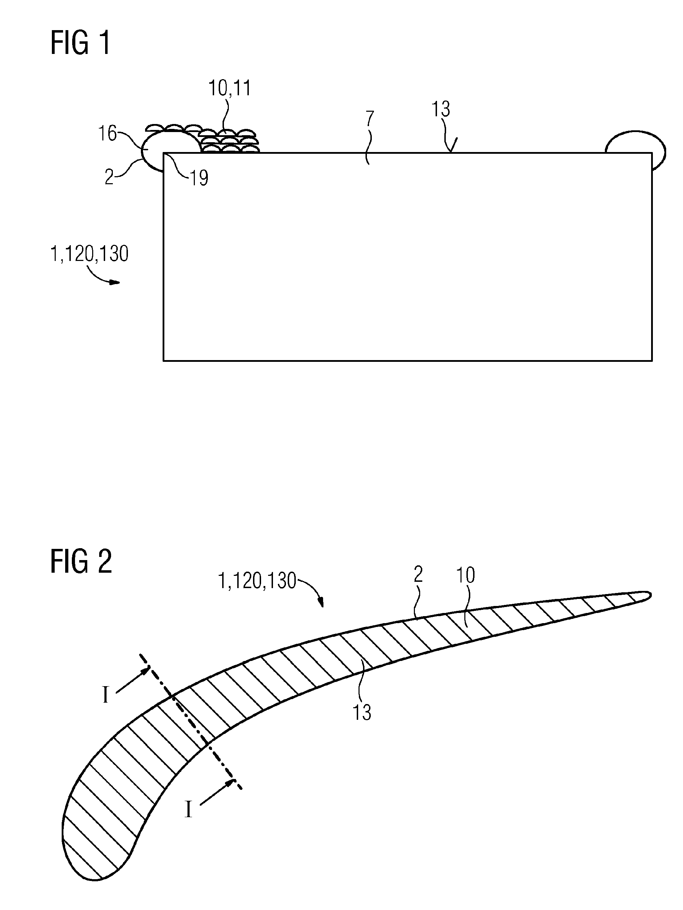

Figur 1 zeigt einen Querschnitt durch ein Substrat 7, bei dem schon teilweise eine Auftragsschweißung vorhanden ist.

Insbesondere der Bereich und die Kante 19 des Substrats 7, hier vorzugsweise eine Schaufelspitze, stellt einen kritischen Bereich dar.

Daher wird zuerst eine Außenkonturschweißung 2 gelegt.

Die Außenkonturschweißung 2 weist vorzugsweise ein anderes, erstes Schweißmaterial 16 als die innenliegenden Schweißbahnen 10 mit einem zweiten Schweißmaterial 11 auf oder ist in der Breite größer als die innenliegenden Schweißbahnen 10.

Anderes Material bedeutet, dass sich zumindest ein Legierungsanteil eines ersten Schweißmaterials 16 um mindestens 20% von dem des zweiten Schweißmaterials 11 unterscheidet.

Entlang der Kante 19 einer zu schweißenden Fläche wird insbesondere ein Material verwendet, das eine geringere Heißrissanfälligkeit aufweist.

Innerhalb dieser Außenkonturschweißung 2 wird dann in die Fläche 13 dazwischen mit einem anderen Schweißmaterial 11 auftragsgeschweißt, das den mechanischen Eigenschaften des Substrats 4 am nächsten kommt.

Ebenso kann die Außenkonturschweißung 2 mit demselben Material generiert werden, ist aber in der Gesamtbreite deutlich größer als die innenliegenden Schweißbahnen 10.

Vorzugsweise ragt die Außenkonturschweißung 2 auch über die Ecke oder Kante 19 hinaus.

Figur 2 zeigt eine Aufsicht auf eine solche Schweißung, bei der die dicke Linie die äußere Außenkonturschweißung 2 darstellt, die vollständig um die zu schweißende Fläche 13 gelegt ist; also vollständig entlang einer Kante 19 verläuft und hier ein Schaufelblattprofil umhüllt. Dabei sind mehrere in beliebiger Form ausgestaltete Schweißbahnen 10 zusätzlich zu dem ersten Material vorhanden.

Ebenso können verschiedene Schweißmaterialien für die Außenkonturschweißung 2 und die innenliegenden Schweißbahnen 10 verwendet werden und eine breitere Außenkonturschweißung 2.

Die Außenkonturschweißung 2 stellt eine einzige Schweißbahn oder Schweißraupe dar.

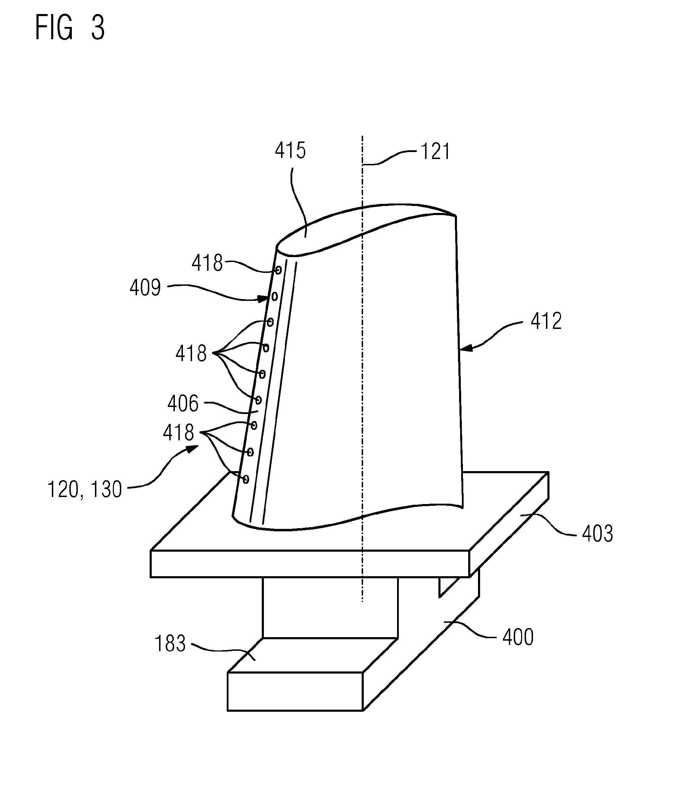

Die Figur 3 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.

Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).

Der Schaufelfuß 183 ist beispielsweise als Hammerkopf ausgestaltet. Andere Ausgestaltungen als Tannenbaum- oder Schwalbenschwanzfuß sind möglich.

Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.

Solche Superlegierungen sind beispielsweise aus der EP 1 204 776 B1, EP 1 306 454, EP 1 319 729 A1, WO 99/67435 oder WO 00/44949 bekannt.

Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.

Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.

Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.

Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures). Solche Verfahren sind aus der US-PS 6,024,792 und der EP 0 892 090 A1 bekannt.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1.

Die Dichte liegt vorzugsweise bei 95% der theoretischen Dichte.

Auf der MCrAlX-Schicht (als Zwischenschicht oder als äußerste Schicht) bildet sich eine schützende Aluminiumoxidschicht (TGO = thermal grown oxide layer).

Vorzugsweise weist die Schichtzusammensetzung Co-30Ni-28Cr-8Al-0,6Y-0,7Si oder Co-28Ni-24Cr-10Al-0,6Y auf. Neben diesen kobaltbasierten Schutzbeschichtungen werden auch vorzugsweise nickelbasierte Schutzschichten verwendet wie Ni-10Cr-12Al-0,6Y-3Re oder Ni-12Co-21Cr-11Al-0,4Y-2Re oder Ni-25Co-17Cr-10Al-0,4Y-1,5Re.

Auf der MCrAlX kann noch eine Wärmedämmschicht vorhanden sein, die vorzugsweise die äußerste Schicht ist, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.

Die Wärmedämmschicht bedeckt die gesamte MCrAlX-Schicht. Durch geeignete Beschichtungsverfahren wie z.B. Elektronenstrahlverdampfen (EB-PVD) werden stängelförmige Körner in der Wärmedämmschicht erzeugt.

Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrAlX-Schicht.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

## Patentansprüche

1. Verfahren
zum Auftragsschweißen einer Fläche (13),
bei dem eine Außenkonturschweißung (2) um die Fläche (13) mit einem ersten Schweißmaterial (16) verwendet wird,
das weniger rissanfällig ist als ein zweites Schweißmaterial (11),
das zwischen der Außenkonturschweißung (2) aufgetragen wird oder
bei dem die Außenkonturschweißung (2) mindestens 50% breiter ausgebildet ist als die Schweißbahnen der innenliegenden Schweißbahnen (10).

2. Verfahren nach Anspruch 1,
bei dem das erste Schweißmaterial (16) für die Außenkonturschweißung (2) ein anderes zweites Schweißmaterial aufweist als das Schweißmaterial (11) der innenliegenden Schweißbahnen (10) auf der zu schweißenden Fläche (13).

3. Verfahren nach einem oder beiden der Ansprüche 1 oder 2, bei dem die Breite der Außenkonturschweißung (2) mindestens 50%, insbesondere mindestens 100% größer ist als die Breite der innenliegenden Schweißbahnen (10).

4. Verfahren nach einem oder mehreren der Ansprüche 1, 2 oder 3,
bei dem die Außenkonturschweißung (2) nur eine Schweißbahn darstellt.

5. Verfahren nach einem oder mehreren der Ansprüche 1, 2, 3 oder 4,
bei dem die Außenkonturschweißung (2) über die Kante (19) der Fläche (13) gelegt wird.

6. Bauteil,
insbesondere hergestellt nach Anspruch 1, 2, 3, 4 oder 5, bei dem eine Außenkonturschweißung (2) aus einem ersten Schweißmaterial (10) vorhanden ist,
das von dem Schweißmaterial (11) der innenliegenden Schweißbahnen (10) verschieden ist
und/oder
die Breite der Außenkonturschweißung (2) mindestens 50%, insbesondere mindestens 100% größer ist als die Breite der innenliegenden Schweißbahnen (10).

7. Bauteil nach Anspruch 6,
bei dem die Außenkonturschweißung (2) über die Kante (19) der Fläche (13) hinausragt.
